# EUROPEAN PATENT APPLICATION

(11) **EP 4 815 695 A1**
(43) Date of publication of application: **30.09.2026**
(21) Application number: 25802656.6
(22) Date of filing: 03.04.2025
(51) Int. Cl.: H10K 59/126, G09F 9/33

(54) **DISPLAY PANEL AND DISPLAY APPARATUS**

(30) Priority: 13.05.2024 CN 202410591334
(71) Applicant: Xiamen Tianma Display Technology Co., Ltd., Xiamen, Fujian 361101 (CN)
(72) Inventor: JIN, Siyu, Xiamen, Fujian 361101 (CN); ZHANG, Cheng, Xiamen, Fujian 361101 (CN); WU, Jianlong, Xiamen, Fujian 361101 (CN); MA, Xiangwen, Xiamen, Fujian 361101 (CN)
(74) Representative: Boult Wade Tennant LLP
(86) International application number: PCT/CN2025/087073
(87) International publication number: WO 2025/236907

(57) **Abstract**

The present application relates to a display panel and a display apparatus. The display panel comprises: a substrate, as well as pixels, a light-shielding conductor structure and first power signal lines located at one side of the substrate. The first end of each first power signal line is electrically connected to a power pad. A non-display area comprises a first non-display area and a second non-display area, the first non-display area, a display area and the second non-display area being arranged in sequence along a first direction, and the power pads being located in the first non-display area. Each pixel comprises a pixel driving circuit, the pixel driving circuit comprising a driving transistor. The light-shielding conductor structure is located at a side of an active layer of the driving transistors close to the substrate. At least one first power signal line is electrically connected to the light-shielding conductor structure by means of at least one first via hole, and, in the extension direction of the first power signal line, the distance between any two first via holes is smaller than the lengths of the first power signal lines.

## Description

### CROSS-REFERENCE TO RELATED APPLICATIONS

This application claims the priority of Chinese Patent Application No. 202410591334.4, filed on May 13, 2024, titled "DISPLAY PANEL AND DISPLAY APPARATUS", the content of which is incorporated by reference in its entirety.

### TECHNICAL FIELD

The present disclosure generally relates to the field of display technologies and, more particularly, relates to a display panel and a display device.

### BACKGROUND

With the continuous development of display technologies, display panels have been widely used in people's lives. In a display panel, the threshold voltage drift of the driving transistors causes uneven brightness of the display screen, affecting the display effect. The present disclosed display panels and display devices are direct to solve such a problem and other problems in the arts.

### SUMMARY

One aspect of the present disclosure provides a display panel. The display panel includes a display area; a non-display area; a substrate; a pixel, a light-shielding conductive structure, and at least one first power signal line located on one side of the substrate. A first end of the first power signal line is electrically connected to a power soldering pad; the non-display area includes a first non-display area and a second non-display area; the first non-display area, the display area and the second non-display area are arranged in sequence along a first direction; the power soldering pad is located in the first non-display area; the pixel includes a pixel driving circuit; the pixel driving circuit includes a driving transistor; the light-shielding conductive structure is located on a side of an active layer of the driving transistor adjacent to the substrate; at least one of the first power signal line is electrically connected to the light-shielding conductive structure through at least one first via hole; and in an extension direction of the first power signal line, a distance between any two first via holes is less than a length of the first power signal line. The at least one first via hole is in contact with a film layer where the light-shielding conductive structure is located.

Another aspect of the present disclosure includes a display device. The display device includes a display panel. The display panel includes a display area; a non-display area; a substrate; a pixel, a light-shielding conductive structure; and at least one first power signal line located on one side of the substrate. A first end of the first power signal line is electrically connected to a power soldering pad; the non-display area includes a first non-display area and a second non-display area; the first non-display area, the display area and the second non-display area are arranged in sequence along a first direction; the power soldering pad is located in the first non-display area; the pixel includes a pixel driving circuit; the pixel driving circuit includes a driving transistor; the light-shielding conductive structure is located on a side of an active layer of the driving transistor adjacent to the substrate; at least one of the first power signal line is electrically connected to the light-shielding conductive structure through at least one first via hole; and in an extension direction of the first power signal line, a distance between any two first via holes is less than a length of the first power signal line. The at least one first via hole is in contact with a film layer where the light-shielding conductive structure is located.

Other aspects of the present disclosure can be understood by those skilled in the art in light of the description, the claims, and the drawings of the present disclosure.

### BRIEF DESCRIPTION OF THE DRAWINGS

To illustrate the technical solutions in the embodiments of the present disclosure more clearly, the following briefly introduces the accompanying drawings used in the description of the embodiments. Obviously, the accompanying drawings in the following description are only some embodiments of the present disclosure, for those of ordinary skill in the art, other drawings can also be obtained from these drawings without creative effort.
FIG. 1 illustrates a partial cross-sectional view of a display panel;
FIG. 2 illustrates a display panel;
FIG. 3 illustrates a connection between a power signal line and a shielding conductive structure;
FIG. 4 illustrates a top view of an exemplary display panel according to various disclosed embodiments of the present disclosure;
FIG. 5 illustrates an A1-A2-sectional view in FIG. 4;
FIG. 6 illustrates a top view of a first power signal line and a first via hole according to various disclosed embodiments of the present disclosure;
FIG. 7 illustrates a B1-B2-sectional view in FIG. 6;
FIG. 8 illustrates another top view of an exemplary display panel according to various disclosed embodiments of the present disclosure;
FIG. 9 illustrates an exemplary pixel circuit structure according to various disclosed embodiments of the present disclosure;
FIG. 10 illustrates another exemplary top view of a first power signal line and a first via hole according to various disclosed embodiments of the present disclosure;
FIG. 11 illustrates another exemplary top view of a first power signal line and a first via hole according to various disclosed embodiments of the present disclosure;
FIG. 12 illustrates another exemplary top view of a first power signal line and a first via hole according to various disclosed embodiments of the present disclosure;
FIG. 13 illustrates another exemplary top view of a first power signal line and a first via hole according to various disclosed embodiments of the present disclosure;
FIG. 14 illustrates another exemplary top view of a first power signal line and a first via hole according to various disclosed embodiments of the present disclosure;
FIG. 15 illustrates an exemplary top view of a first power signal line and a second via hole according to various disclosed embodiments of the present disclosure;
FIG. 16 illustrates a cross-sectional view of an exemplary display panel according to various disclosed embodiments of the present disclosure;
FIG. 17 illustrates another cross-sectional view of an exemplary display panel according to various disclosed embodiments of the present disclosure;
FIG. 18 illustrates another cross-sectional view of an exemplary display panel according to various disclosed embodiments of the present disclosure;
FIG. 19 illustrates another cross-sectional view of an exemplary display panel according to various disclosed embodiments of the present disclosure;
FIG. 20 illustrates another cross-sectional view of an exemplary display panel according to various disclosed embodiments of the present disclosure;
FIG. 21 illustrates a partial layout structure of an exemplary light-shielding conductive structure according to various disclosed embodiments of the present disclosure;
FIG. 22 illustrates another partial layout structure of an exemplary light-shielding conductive structure according to various disclosed embodiments of the present disclosure; and
FIG. 23 illustrates an exemplary display device according to various disclosed embodiments of the present disclosure.

### DETAILED DESCRIPTION

To more clearly understand the above-mentioned purpose, features and advantages of the present disclosure, the scheme of the present disclosure will be further described below. It should be noted that, in the absence of conflict, the embodiments of the present disclosure and the technical features in the embodiments can be combined with each other.

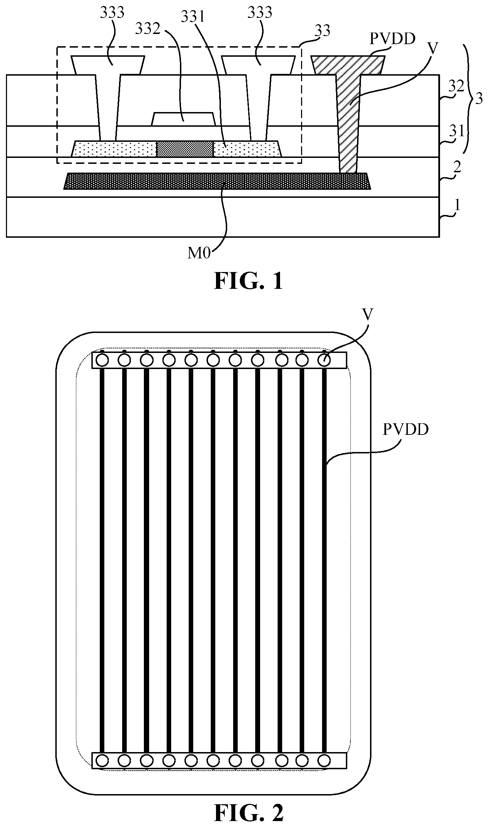

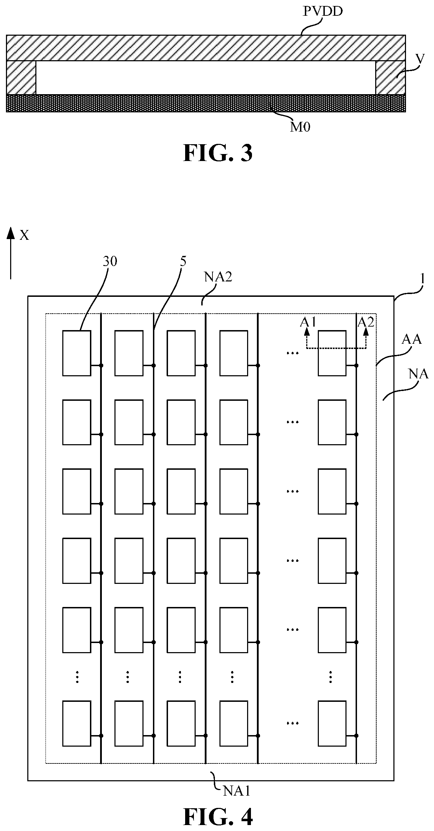

FIG. 1 is a schematic diagram of a partial cross-sectional structure of a display panel. As shown in FIG. 1, the display panel includes a substrate 1, a buffer layer 2, a light-shielding layer M0 located in the buffer layer 2, and a pixel circuit layer 3 located on the side of the buffer layer 2 away from the substrate 1. The pixel circuit layer 3 includes a pixel driving circuit and a signal line. The pixel driving circuit includes a driving transistor 33, and the signal line includes a positive power signal line PVDD. The driving transistor 33 includes an active layer 331, a gate layer 332 and a source/drain layer 333. A gate insulation layer 31 is provided between the active layer 331 and the gate layer 332, and an interlayer insulation layer 32 is provided between the gate layer 332 and the source/drain layer 333. The light-shielding layer M0 can shield the light incident from the bottom of the display panel, preventing the light from being transmitted to the channel region of the active layer 331, thereby preventing the generation of photogenerated leakage current in the channel region. Moreover, the light-shielding layer M0 can also reduce the influence of electrostatic discharge on the driving transistor 33. At the same time, the light-shielding layer M0 is connected to a constant potential, for example, the light-shielding layer M0 is electrically connected to the positive power signal line PVDD through a via hole V, which can reduce the electrical drift of the driving transistor 33 caused by static electricity. Therefore, as shown in FIG. 2 and FIG. 3, both ends of the positive power signal line PVDD are electrically connected to the light-shielding layer M0 through a via hole V at the same time, thereby reducing the electrical drift of the driving transistor 33 caused by static electricity. However, it has been found that when both ends of the positive power signal line PVDD are electrically connected to the light-shielding layer M0 through the via hole V at the same time, the voltage of the light-shielding layer M0 in the entire display area will change with the voltage of the positive power signal line PVDD; and when the display panel is displayed, the positive power signal line PVDD provides voltage for the pixel driving circuit, and there is voltage loss, which makes the voltage drop at both ends of the positive power signal line PVDD large, resulting in a large voltage difference on the light-shielding layer M0. Moreover, the smaller the voltage on the light shielding layer M0 is, the more the voltage threshold of the driving transistor 33 drifts toward the positive direction, and the display brightness of the corresponding pixel will be lower, resulting in the display brightness of the display panel gradually decreasing along the extension direction of the positive power signal line PVDD.

The present disclosure provides a display panel and a display device. In the display panel provided by the embodiment of the present disclosure, the first power signal line may be electrically connected to the light-shielding conductive structure through at least one first via hole, and in the extension direction of the first power signal line, the distance between any two first via holes may be less than the length of the first power signal line such that the voltage drop on the light-shielding conductive structure may be less than the voltage drop at both ends of the first power signal line, thereby improving the uniformity of the voltage distribution on the light-shielding conductive structure, the difference in threshold voltages between driving transistors may be reduced, and the uniformity of the brightness of the display screen may be improved.

The above is the core idea of the present disclosure. The technical scheme in the embodiment of the present disclosure will be clearly and completely described below in conjunction with the drawings in the embodiments of the present disclosure. Based on the embodiment of the present disclosure, all other embodiments obtained by ordinary technicians in this field without creative work are within the scope of protection of the present disclosure.

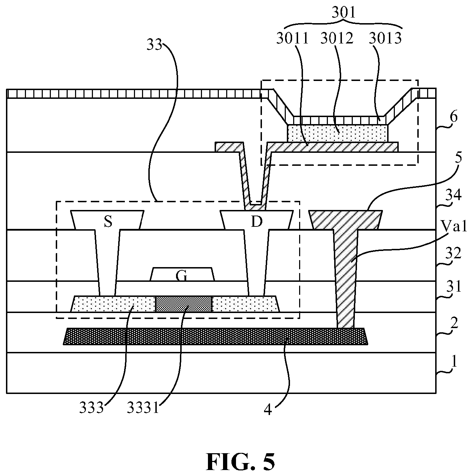

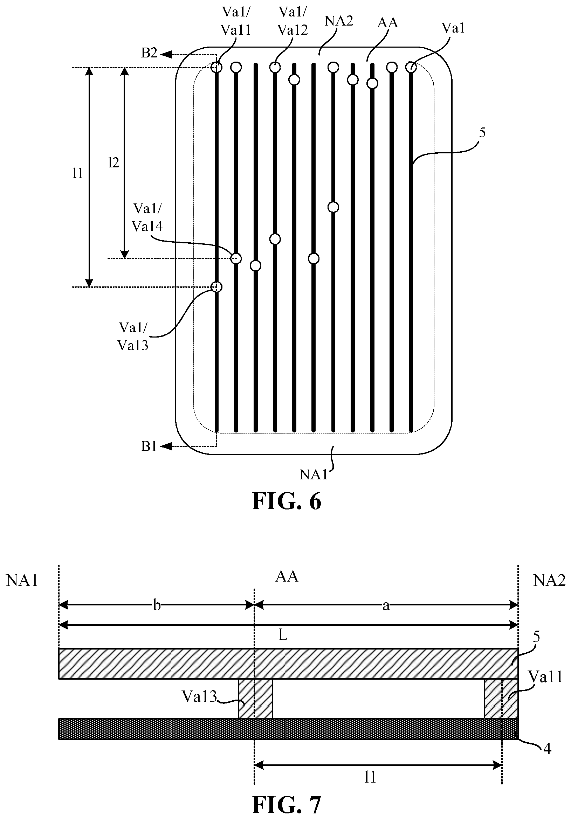

FIG. 4 is a top view schematic diagram of an exemplary display panel according to various embodiments of the present disclosure. FIG. 5 is a cross-sectional schematic diagram in the A1-A2 direction of FIG. 4. FIG. 6 is a top view schematic diagram of a first power signal line and a first via hole according to various disclosed embodiments of the present disclosure. FIG. 7 is a cross-sectional schematic diagram in the B1-B2 direction of FIG. 6.

As shown in FIGS. 4-7, a display panel provided by an embodiment of the present disclosure may include a display area AA and a non-display area NA. Further, the display panel may include a substrate 1, a pixel 30, a light-shielding conductive structure 4 and at least one first power signal line 5 located on one side of the substrate 1. A first end of the first power signal line 5 may be electrically connected to a power soldering pad (not shown in the figure). The non-display area NA may include a first non-display area NA1 and a second non-display area NA2. The first non-display area NA1, the display area AA and the second non-display area NA2 may be arranged in sequence along a first direction X, and the power soldering pad may be located in the first non-display area NA1. The pixel 30 may include a pixel driving circuit. The pixel driving circuit may include a driving transistor 33, and the light-shielding conductor structure 4 may be located on a side of the active layer 333 of the driving transistor 33 adjacent to the substrate 1. At least one first power signal line 5 may be electrically connected to the light-shielding conductive structure 4 through at least one first via hole Va1. In the extension direction of the first power signal line 5, the distance between any two first vias holes Va1 may be less than the length L of the first power signal line 5. The first via hole Va1 may be in contact with the film layer where the light-shielding conductive structure 4 is located.

In one embodiment, the light-shielding conductive structure 4 may be a light-shielding metal layer, and in the direction perpendicular to the plane where the substrate 1 is located, the channel region 3331 of the active layer 333 of the driving transistor 33 may be covered by the light-shielding conductive structure 4. At the same time, when the light-shielding conductive structure 4 is electrically connected to the first power signal line 5, the light-shielding conductive structure 4 may not only block the light incident from the bottom to avoid the generation of photogenerated leakage current in the channel region 3331 of the active layer 333 of the driving transistor 33, but also play an anti-static role to improve the electrical drift of the driving transistor 33. The light-shielding conductive structure 4 may be arranged between the active layer 333 of the driving transistor 33 and the substrate 1. In one embodiment, the display panel may also include a buffer layer 2 located between the driving transistor 33 and the substrate 1, and the light-shielding conductive structure 4 may be arranged in the buffer layer 2. In this way, when the display panel is subjected to an external force, because the light-shielding conductive structure 4 is placed inside the buffer layer 2 and is covered by the buffer layer 2, the risk of the light-shielding conductive structure 4 falling off may be reduced.

Further, the first power signal line 5 may be located in the display area AA, and may include a first end and a second end opposite to each other. The first end and the second end may be both located at the boundary of the display area AA, and the length L of the first power signal line 5 may be the distance between the first end and the second end. The power soldering pad may be used to electrically connect the first power signal line 5 and the integrated chip, and introduce the first power signal output by the integrated chip into the first power signal line 5. The first power signal may be input from the first end of the first power signal line 5, and may be transmitted to the corresponding electrically connected pixel 30 through the first power signal line 5 to provide the power signal for the pixel 30.

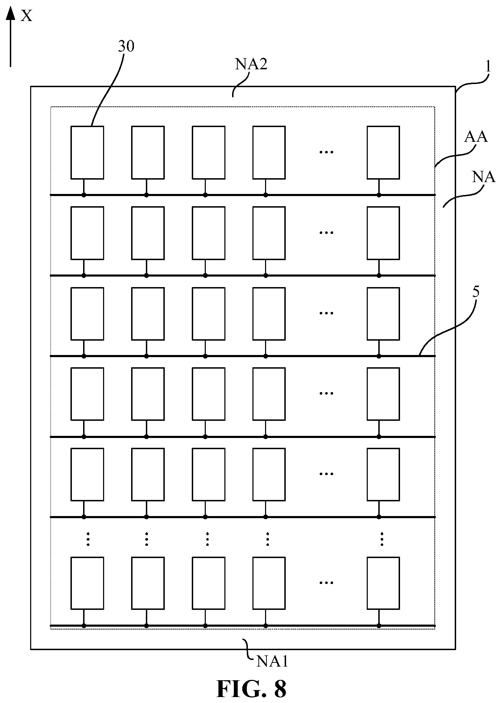

In one embodiment, the first power signal line 5 may be a power signal line with a voltage drop, such as a positive power signal line (PVDD), a negative power signal line (PVEE) or a reset power signal line (VREF). Among them, considering that the voltage drop of the positive power signal line may have a greater impact on the display uniformity of the display panel, in some embodiments, the first power signal line 5 may be a positive power signal line. Correspondingly, the pixel driving circuit may also include a storage capacitor. The first plate of the storage capacitor may be electrically connected to the first power signal line, and the second plate of the storage capacitor may be electrically connected to the gate G of the driving transistor 33. Thus, the light-shielding conductive structure 4 may be electrically connected to the positive power signal line through the first via hole Va1, which may not only improve the uniformity of the voltage distribution of the light-shielding conductive structure 4, but also reduce the resistance of the positive power signal line, and further improve the display uniformity of the display panel. When the first power signal line 5 is a positive power signal line, the arrangement of the first power signal line 5 may be as shown in FIG. 4. At this time, the extension direction of the first power signal line 5 may be parallel to the first direction X. In addition, in other embodiments, the extension direction of the first power signal line 5 may intersect with the first direction X. As shown in FIG. 8, the first power signal line 5 may be a reset power signal line (see below for details), and the first power signal line 5 may be perpendicular to the first direction X.

In one embodiment, at least one first power signal line 5 may be electrically connected to the light-shielding conductive structure 4 through at least one first via hole Va1, and in the extension direction of the first power signal line 5, the distance between any two first via hole Va1 may be less than the length L of the first power signal line 5, thereby reducing the voltage drop of the light-shielding conductive structure 4, improving the uniformity of the voltage distribution on the light-shielding conductive structure 4, and thus improving the display uniformity of the display panel. Among them, for the distance between the two first via holes Va1, specifically, when the orthographic projections of the two via holes on the power line projection coincide, the distance between the two first via holes corresponding to the two via hole projections may be 0; and when the orthographic projections of the two via holes on the power line projection do not coincide, and the distance between the two first via holes corresponding to the two via hole projections may be the length between the orthographic projections. The via hole projection may be the positive projection of the first via hole on the target projection surface, the power line projection may be the positive projection of a first power signal line on the target projection surface, and the target projection surface may be the plane where the substrate is located or parallel to the plane where the substrate is located.

In one embodiment, for the case where the orthographic projections of the two via holes on the power line projection coincide, the corresponding two first via holes Va1 may be arranged along the arrangement direction of the first power signal line 5. For example, referring to FIG. 6, the first via hole Va1 may include a first sub-via hole Va11 and a second sub-via hole Va12. In the extension direction of the first power signal line 5, the distance between the first sub-via hole Va11 and the second sub-via hole Va12 may be 0. In the case where the orthographic projections of the two via holes on the power line projection do not overlap, the corresponding two first via holes Va1 may correspond to the same first power signal line 5, or may correspond to different first power signal lines 5. For example, referring to FIG. 6, the first via Va1 may also include a third sub-via Va13 and a fourth sub-via Va14. The first sub-via Va11 and the third sub-via Va13 may correspond to the same first power signal line 5, and the first sub-via Va11 and the fourth sub-via Va14 may correspond to different first power signal lines 5. The plane where the light-shielding conductive structure 4 is located or the plane where the first power signal line 5 is located may be used as the target projection plane. In the extension direction of the first power signal line 5, the distance between the first sub-via Va11 and the third sub-via Va13 may be 11, and the distance between the first sub-via Va11 and the fourth sub-via Va14 may be 12. Both 11 and 12 may be smaller than the length L of the first power signal line 5.

It should be noted that the light-shielding conductive structure 4 may be arranged in a grid shape in the entire display area AA. At this time, when only one first power signal line 5 is electrically connected to the light-shielding conductive structure 4 through a first via hole Va, it may set that the distance between the two first via holes Va1 in the extension direction of the first power signal line 5 may be 0. Further, the light-shielding conductive structure 4 may also be arranged corresponding to the first power signal line 5. At this time, when a first power signal line 5 is electrically connected to the light-shielding conductive structure 4 through a first via hole Va, it may be set that the distance between the two first via holes Va1 corresponding to the first power signal line 5 in the extension direction of the first power signal line 5 may be 0.

In addition, it may be understood that the first via hole Va1 may contact the film layer where the light-shielding conductive structure 4 is located, and the first via hole Va1 may be directly in contact with the light-shielding conductive structure 4, or the first via Va1 may be in contact with other conductive structures of the film layer where the light-shielding conductive structure 4 is located to achieve the electrical connection between the first via hole Va1 and the light-shielding conductive structure 4.

The structure shown in FIG. 7 is taken as an example below to illustrate the principle that the embodiment of the present disclosure may improve the uniformity of voltage distribution on the light-shielding conductive structure 4. As shown in FIG. 7, the first power signal line 5 may be electrically connected to the light-shielding conductive structure 4 through the first sub-via hole Va11 and the third sub-via hole Va13 in the first via Va1. The distance between the first sub-via hole Vall and the third sub-via hole Va13 may be 11, and 11 may be less than the length L of the first power signal line 5. The portion of the light-shielding conductive structure 4 located between the first sub-via Va11 and the third sub-via Va13 may be called the first portion, which may be located in an *a* interval, and the other portion of the light-shielding conductive structure 4 may be called the second portion, which may be located in the b interval. When the display panel is in operation, the voltage of the first portion of the light-shielding conductive structure 4 may change with the voltage of the first power signal line 5 in the *a* interval, while the change in the voltage of the second portion of the light-shielding conductive structure 4 may only be related to the material of the light-shielding conductive structure 4. Therefore, the voltage drop of the second portion may be relatively small such that the overall voltage drop of the light-shielding conductive structure 4 may be smaller than the voltage drop at both ends of the first power signal line 5. As a result, the uniformity of the voltage distribution on the light-shielding conductive structure 4 may be improved, thereby improving the uniformity of the display panel screen.

In some embodiments, referring to FIG. 5, the driving transistor may include a gate G, an active layer 333, a source S and a drain D. The gate G may be located in the gate layer, and the source S and the drain D may be located in the source/drain layer. A gate insulation layer 31 may be provided between the active layer 331 and the gate layer, and an interlayer insulation layer 32 may be provided between the gate layer and the source/drain layer. A planarization layer 34 may be provided on the side of the driving transistor 33 away from the substrate 1. In one embodiment, the gate G may be located on the side of the active layer 333 of the driving transistor 33 away from the substrate 1. The driving transistor 33 may be a top gate structure, such as a low-temperature polysilicon transistor such that the gate G may be used to block a portion of the light emitted by the light-emitting element and transmitted toward the active layer 333, further avoiding the generation of photogenerated leakage current in the channel region 3331. In addition, the pixel may also include a light-emitting element 301, at least part of the light-emitting element 301 may be located in the opening of the pixel definition layer 6, and the pixel definition layer 6 may be located on the side of the planarization layer 34 away from the substrate 1. The light-emitting element 301 may include an anode 3011, a cathode 3013, and a light-emitting layer 3012 located between the anode 3011 and the cathode 3013. The anode 3011 may be electrically connected to the drain D of the driving transistor 33. The driving transistor 33 may drive the light-emitting element 301 to emit light.

The pixel driving circuit may be set in various ways. For example, the pixel driving circuit may be a circuit with a circuit structure of "7T1C", "7T2C", or "8T1C", etc. "T" may represent a transistor and "C" may represent a capacitor. The following is an exemplary description of the pixel driving circuit with a "7T1C" structure.

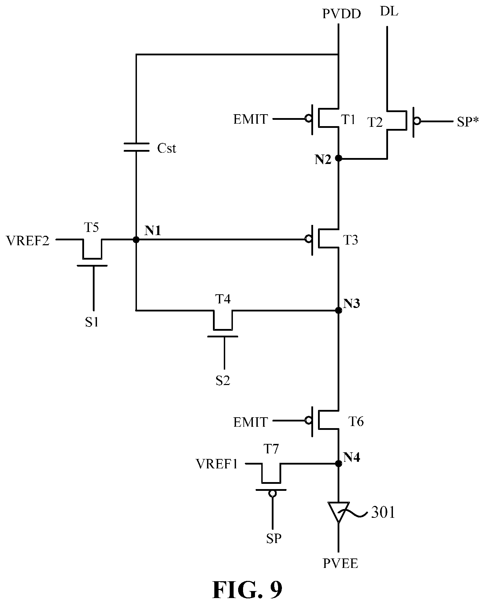

As shown in FIG. 9, the pixel driving circuit may include a first light-emitting control transistor T1, a data writing transistor T2, a driving transistor T3 (i.e., the driving transistor 33), a compensation transistor T4, a first reset transistor T7, a second reset transistor T5, and a second light-emitting control transistor T6; and the pixel driving circuit may also include a storage capacitor Cst. Among them, the first electrode of the first light-emitting control transistor T1 may be electrically connected to the positive power signal line PVDD, the second electrode of the first light-emitting control transistor T1 may be electrically connected to the second node N2, and the gate of the first light-emitting control transistor T1 may be electrically connected to the light-emitting control scanning signal line EMIT. The first electrode of the data writing transistor T2 may be electrically connected to the data line DL, the second electrode of the data writing transistor T2 may be electrically connected to the second node N2, and the gate of the data writing transistor T2 may be electrically connected to the third scanning signal line SP*. The first electrode of the driving transistor T3 may be electrically connected to the second node N2, the second electrode of the driving transistor T3 may be electrically connected to the third node N3, and the gate of the driving transistor T3 may be electrically connected to the first node N1. The first electrode of the compensation transistor T4 may be electrically connected to the first node N1, the second electrode of the compensation transistor T4 may be electrically connected to the third node N3, and the gate of the compensation transistor T4 may be electrically connected to the second scanning signal line S2. The first electrode of the second reset transistor T5 may be electrically connected to the second reset power signal line VREF2, the second electrode of the second reset transistor T5 may be electrically connected to the first node N1, and the gate of the second reset transistor T5 may be electrically connected to the first scan signal line S1. The first electrode of the second light-emission control transistor T6 may be electrically connected to the third node N3, the second electrode of the second light-emission control transistor T6 may be electrically connected to the fourth node N4, and the gate of the second light-emission control transistor T6 may be electrically connected to the light-emission control scan signal line EMIT. The first electrode of the first reset transistor T7 may be electrically connected to the first reset power signal line VREF1, the second electrode of the first reset transistor T7 may be electrically connected to the fourth node N4, and the gate of the second reset transistor T7 may be electrically connected to the bias control signal line SP. The second plate of the storage capacitor Cst may be electrically connected to the first node N1, and the first plate of the storage capacitor Cst may be electrically connected to the positive power signal line PVDD. Accordingly, a pixel driving circuit of a 7T1C structure may be realized.

Specifically, for the working process of the pixel driving circuit, with reference to FIG. 2 and FIG. 4, for example, the first scanning signal VS1 of the first scanning signal line S1 may control the conduction or disconnection of the second reset transistor T5 of the pixel driving circuit, and reset the gate potential of the driving transistor T3 when the second reset transistor T5 is turned on, and the second reset power signal of the second reset power signal line VREF2 may be transmitted to the second reset transistor T5 and the connection node (first node N1) of the driving transistor T3, the second reset transistor T5, the compensation transistor T4 and the storage capacitor Cst may be reset. The third scanning signal VSP* of the third scanning signal line SP* may control the conduction and disconnection of the data writing transistor T2 of the pixel driving circuit, and when the data writing transistor T2 is turned on, the data signal on the data signal line DL may be written to the gate of the driving transistor T3. The second scan signal VS2 of the second scan signal line S2 may control the on and off of the compensation transistor T4, and compensate the threshold voltage of the driving transistor T3 when the compensation transistor T4 is on. At the same time, the bias control signal line SP may control the on and off of the first reset transistor T7, and reset the anode of the light-emitting element 301 connected to the pixel driving circuit when the first reset transistor T7 is on, that is, the first reset power signal of the first reset power signal line VREF1 may be transmitted to the anode of the light-emitting element 301. The light-emitting control scan signal VEMIT of the light-emitting control scan signal line EMIT may control the on and off of the first light-emitting control transistor T1 and the second light-emitting control transistor T6, and transmit the signal of the positive power signal line PVDD to the light-emitting element 301 when the first light-emitting control transistor T1 and the second light-emitting control transistor T6 are controlled to be on, thereby realizing the display and light emission of the light-emitting element 301.

It can be understood that the first node N1, the second node N2, the third node N3 and the fourth node N4 may be virtual connection nodes, or actual connection nodes.

The display panel provided by the embodiments of the present disclosure may electrically connect the first power signal line 5 to the light-shielding conductive structure 4 through at least one first via hole Va1, and in the extension direction of the first power signal line 5, the distance between any two first via holes Va1 may be less than the length L of the first power signal line 5 such that the voltage drop on the light-shielding conductive structure 4 may be less than the voltage drop at both ends of the first power signal line 5, thereby improving the uniformity of the voltage distribution on the light-shielding conductive structure 4, thereby reducing the difference in threshold voltages between the driving transistors 33, and thereby improving the uniformity of the brightness of the display screen.

In some embodiments, the first via hole may be located in the non-display area. Specifically, the first via hole may be located in the non-display area in the extension direction of the first power signal line. For example, when the first power signal line extends along the first direction, the first via may be located in the first non-display area or the second non-display area. Thus, the first via hole may be prevented from occupying the space of the display area, which may be conducive to realizing a display panel with a high pixel density.

It can be understood that because the width of the non-display area may be much smaller than the length of the first power signal line, the first via hole may be set in the non-display area, and the voltage drop on the light-shielding conductive structure may be basically related to the material of the light-shielding conductive structure, the voltage drop on the light-shielding conductive structure may be much smaller than the voltage drop at both ends of the first power signal line.

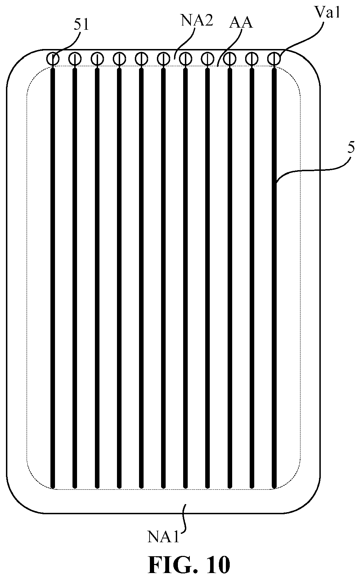

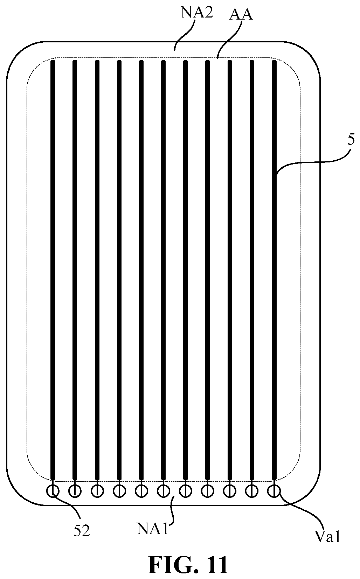

Specifically, in some embodiments, as shown in FIG. 10, the display panel may also include a power extension line 51 electrically connected to the first power signal line 5, the first via hole Va1 and the power extension line 51 may be both located in the second non-display area NA2, and the light-shielding conductive structure may be electrically connected to the power extension line 51 through the first via hole Va1. In some other embodiments, as shown in FIG. 11, the display panel may also include a power lead 52 electrically connected to the first power signal line 5 (each first power signal line 5 may be connected to the power bus through the power lead 52, and the power bus may be electrically connected to the power soldering pad), the first via hole Va1 and the power lead 52 may be both located in the first non-display area NA1, and the light-shielding conductive structure may be electrically connected to the power lead 52 through the first via hole Va1. In the above configurations, the power extension line 51 or the power lead 52 electrically connected to the first power signal line 5 may be used to realize the electrical connection between the light-shielding conductive structure and the first power signal line 5 through the first via hole Va1 located in the non-display area, thereby avoiding the first via hole Va1 occupying the space of the display area, which may be conducive to realizing a display panel with a high pixel density.

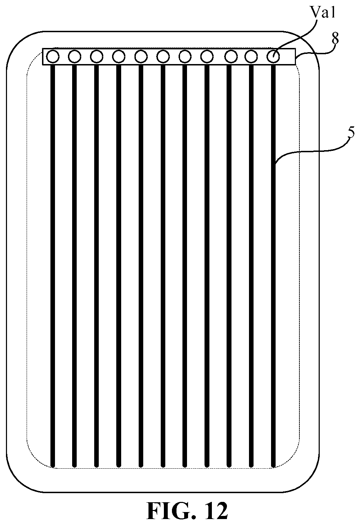

In some embodiments, as shown in FIG. 12, the display panel may also include a connection bus 8, and multiple first power signal lines 5 may be electrically connected to the light-shielding conductive structure through the connection bus 8. On the basis that the first power signal line 5 may be electrically connected to the light-shielding conductive structure through the first via holeVa1, the multiple first power signal lines 5 may be electrically connected to the light-shielding conductive structure through the connection bus 8, then at least a portion of the first via holes Va1 may be electrically connected to the connection bus 8. At this time, the at least portion of the first via holes Va1 may be at the same potential such that the light-shielding conductive structure and the voltage at the connection points of the at least portion of the first via holes Va1 may be same, thereby further improving the uniformity of the voltage distribution on the light-shielding conductive structure. In addition, considering that the first power signal line 5 may not overlap with the light-shielding conductive structure at the first via hole Va1 in the direction perpendicular to the plane where the substrate is located, the light-shielding conductive structure and the first power signal line 5 may be electrically connected by the connection bus 8 in cooperation with the first via hole Va1.

In some embodiments, the connection bus may cover the first via hole in the direction perpendicular to the plane where the substrate is located. In one embodiment, the connection bus may cover the first via hole, that is, each first via hole may be arranged in a line along the connection bus. At this time, each first via hole may have the same potential such that the voltage at the connection point of the light-shielding conductive structure and the first via hole may be same, thereby further improving the uniformity of the voltage distribution on the light-shielding conductive structure.

In some embodiments, in the extension direction of the first power signal line, the distance between any two first via holes may be equal to 0; and in the direction perpendicular to the plane where the substrate is located, the first via hole may overlap with the connection line of the first end of each first power signal line.

In one embodiment, in the extension direction of the first power signal line, the distance between any two first via holes may be equal to 0, that is, in the arrangement direction of the first power signal lines, the first via holes may be arranged in a line. At the same time, in the direction perpendicular to the plane where the substrate is located, the first via hole may overlap with the connection line of the first ends of the first power signal lines, and the first ends of the first power signal lines may also be arranged in a line along the arrangement direction of the first power signal lines such that the first via holes may be located in the arrangement area of the first ends of the first power signal lines. At this time, the voltage at the first via hole may be equal to the input voltage on the first power signal line, so that the voltage at the connection point of the light-shielding conductive structure and the first via hole may be basically the same, thereby further improving the uniformity of the voltage distribution on the light-shielding conductive structure.

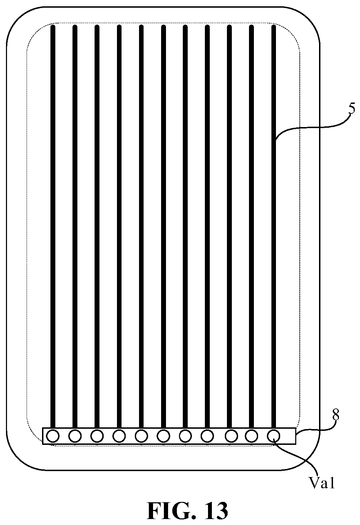

In one embodiment, referring to FIG. 13, the first end of each first power signal line 5 may be electrically connected to the light-shielding conductive structure through the connection bus 8. At this time, in the direction perpendicular to the plane where the substrate is located, the connection bus 8 may cover each first via hole Va1. On the one hand, the voltage at the connection point between the light-shielding conductive structure and the first via hole Va1 may be same, further improving the uniformity of the voltage distribution on the light-shielding conductive structure. On the other hand, when the first end of the first power signal line 5 does not overlap with the light-shielding conductive structure in the direction perpendicular to the plane where the substrate is located, the first via hole Va1 may be connected to the connection bus 8 to achieve the electrical connection between the first end of the first power signal line 5 and the light-shielding conductive structure. In such a configuration, the first power signal line may be set to be the positive power signal line PVDD, the input voltage of the positive power signal line PVDD may be approximately 4.6V, and the input voltage of the negative power signal line PVEE may be approximately -3.2V. Through a simulation, the maximum voltage drop of the light-shielding conductive structure in the display area may be 0.0173V. Under the same simulation conditions, when both ends of the positive power signal line PVDD are electrically connected to the light-shielding conductive structure through vias at the same time, the maximum voltage drop of the light-shielding conductive structure in the display area may be 0.1275V. Therefore, this approach may significantly reduce the voltage drop of the light-shielding conductive structure.

In some embodiments, in the extension direction of the first power signal line, the distance between any two first via hole may be equal to 0. In the direction perpendicular to the plane where the substrate is located, the first via may overlap with the connection line of the second end of each first power signal line. The second end may be the end of the first power signal line opposite to the first end.

In one embodiment, in the extension direction of the first power signal line, the distance between any two first via holes may be equal to 0, that is, in the arrangement direction of the first power signal line, the first via holes may be arranged in a line. At the same time, in the direction perpendicular to the plane where the substrate is located, the first via hole may overlap with the connection line of the second end of each first power signal line, and the second end of each first power signal line may also be arranged in a line along the arrangement direction of the first power signal line, thus each first via hole may be located in the arrangement area of the second end of each first power signal line. At this time, the voltage at the first via hole may be equal to the terminal voltage on the first power signal line. Accordingly, the voltage at the connection point between the light-shielding conductive structure and the first via hole may be substantially the same, thereby further improving the uniformity of the voltage distribution on the light-shielding conductive structure.

In one embodiment, referring to FIG.12, the second end of each first power signal line 5 may be electrically connected to the light-shielding conductive structure through the connection bus 8. At this time, in the direction perpendicular to the plane where the substrate is located, the connection bus 8 may cover each first via hole Va1. On the one hand, the voltage at the connection point between the light-shielding conductive structure and the first via hole Va1 may be the same, further improving the uniformity of the voltage distribution on the light-shielding conductive structure. On the other hand, when the second end of the first power signal line 5 does not overlap with the light-shielding conductive structure in the direction perpendicular to the plane where the substrate is located, the first via hole Va1 may be connected to the connection bus 8 to achieve the electrical connection between the second end of the first power signal line 5 and the light-shielding conductive structure. In this preferred example, the first power signal line may be set to be the positive power signal line PVDD, the input voltage of the positive power signal line PVDD may be approximately 4.6V, and the input voltage of the negative power signal line PVEE may be -3.2V. Through simulation, the maximum voltage drop of the light-shielding conductive structure in the display area may be approximately 0.0003V, and the voltage drop of the light-shielding conductive structure may be further reduced.

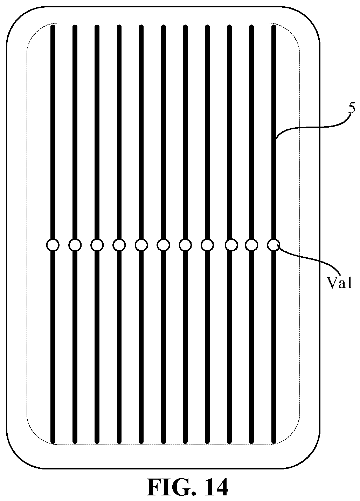

In addition, in some embodiments, referring to FIG. 14, in a direction perpendicular to the plane where the substrate is located, the first via hole Va1 may also be located between the connection line of the first end of each first power signal line 5 and the connection line of the second end of each first power signal line 5. The second end may be an end of the first power signal line opposite to the first end.

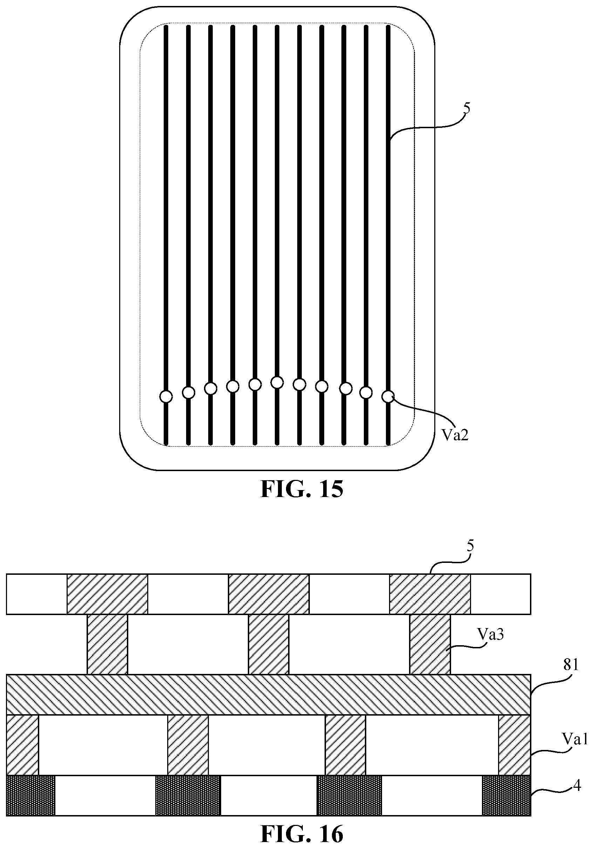

In some embodiments, referring to FIG. 15, the first power signal line 5 may also be electrically connected to the light-shielding conductive structure through the second via hole Va2, and the second via hole Va2 may be in contact with the film layer where the first power signal line 5 is located. For such a configuration, at least two first power signal lines 5 may have the same voltage at the second via hole.

Specifically, the second via hole Va2 may be the same via hole as the first via hole, or may be a different via hole that penetrates a different film layer from the first via hole, and may be specifically set according to the film thickness between the first power signal line 5 and the light-shielding conductive structure, the punching technology, and the product requirements. In one embodiment, the second via hole Va2 and the first via holes are different via holes, the second via hole Va2 may contact the first power signal line 5, the first via hole may contact the light-shielding conductive structure, and the second via hole Va2 and the first via hole Va1 may be staggered and electrically connected, such that the light-shielding conductive structure may electrically connected to the first power signal line 5 through the first via hole Va1 and the second via hole Va2. Further, at least two first power signal lines 5 may have the same voltage at the second via hole Va2 such that the voltage at the corresponding first via hole Va1 may be same, and the light-shielding conductive structure may have the same voltage at the connection point with the corresponding first via hole, thereby improving the uniformity of voltage distribution on the light-shielding conductive structure. In one embodiment, the voltage of each first power signal line 5 at the second via hole may be same. Thus, the uniformity of voltage distribution on the light-shielding conductive structure may be further improved.

FIG. 16 is a cross-sectional schematic diagram of an exemplary display panel provided according to various disclosed embodiments of the present disclosure. As shown in FIG. 16, the connection bus may include a first connection bus 81, and the first connection bus 81 may be located between the film layer where the first power signal line 5 is located and the film layer where the light-shielding conductive structure 4 is located. The first power signal line 5 may be electrically connected to the first connection bus 81 through the third via hole Va3, and the light-shielding conductive structure 4 may be electrically connected to the first connection bus 81 through the first via hole Va1. In such a configuration, when the film layer between the first power signal line 5 and the light-shielding conductive structure 4 is thick and the first power signal line 5 and the light-shielding conductor structure 4 may not be electrically connected through a via hole, but a first connection bus 81 may be provided between the film layer where the first power signal line 5 is located and the film layer where the light-shielding conductive structure 4 is located such that the light-shielding conductive structure 4 may be electrically connected to the first connection bus 81 through the first via hole Va1, and the first connection bus 81 may be electrically connected to the light-shielding conductive structure 4 through the first via hole Va1. The first power signal line 5 may be electrically connected to the first connection bus 81 through the third via hole Va3, thereby realizing the electrical connection between the first power signal line 5 and the light-shielding conductive structure 4. Moreover, the voltage of the light-shielding conductive structure 4 at the connection point with the first via hole Va1 may be equal to the voltage of the first power signal line 5 at the connection point with the third via hole Va3, thereby improving the uniformity of the voltage distribution on the light-shielding conductive structure 4. In some embodiments, in the direction perpendicular to the plane where the substrate is located, the first via hole Va1 and the third via hole Va3 may not overlap to meet the punching design requirements.

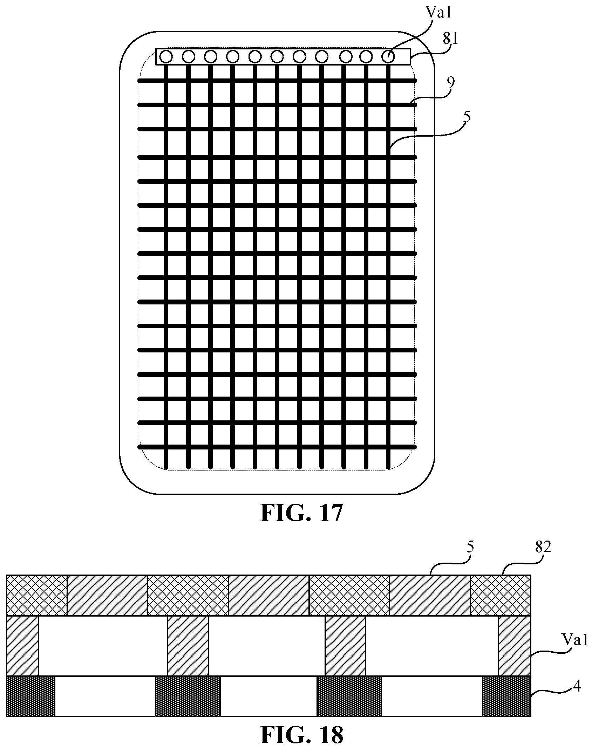

In some embodiments, referring to FIG. 17, the display panel may also include a second power signal line 9. The extension direction of the second power signal line 9 may intersect with the extension direction of the first power signal line 5, and the second power signal line 9 may be electrically connected to the first power signal line 5. The first connection bus 81 and the second power signal line 9 may be located on the same layer.

In one embodiment, the first connection bus 81 may be located between the film layer where the first power signal line 5 is located and the film layer where the light-shielding conductive structure is located. The first connection bus 81 and the second power signal line 9 may be located in the same layer, so the second power signal line 9 and the first power signal line 5 may be located in different layers. At the same time, the second power signal line 9 and the first power signal line 5 may be cross-electrically connected in a grid shape, thereby reducing the resistance of the first power signal line 5, and correspondingly reducing the voltage drop on the first power signal line 5, thereby reducing the voltage drop of the first portion of the light-shielding conductive structure that changes with the voltage of the first power signal line 5, thereby further improving the uniformity of the voltage distribution on the light-shielding conductive structure. In one embodiment, the first power signal line 5 may be a longitudinal positive power signal line, and the second power signal line 9 may be a transverse positive power signal line.

FIG. 18 is a cross-sectional schematic diagram of another exemplary display panel according to various disclosed embodiments of the present disclosure. As shown in FIG. 18, in one embodiment, the connection bus may include a second connection bus 82. The second connection bus 82 may be located at the same layer as the first power signal line 5 and may be electrically connected to the first power signal line 5. The light-shielding conductive structure 4 may be electrically connected to the second connection bus 82 through the first via hole Va1. In this way, the light-shielding conductive structure 4 may be electrically connected to the first power signal line 5 through the first via hole Va1 and the second connection bus 82, which may reduce the alignment requirements of the first power signal line 5 and the light-shielding conductive structure 4. For example, in the direction perpendicular to the plane where the substrate is located, the first power signal line 5 may not be required to overlap with the light-shielding conductive structure 4.

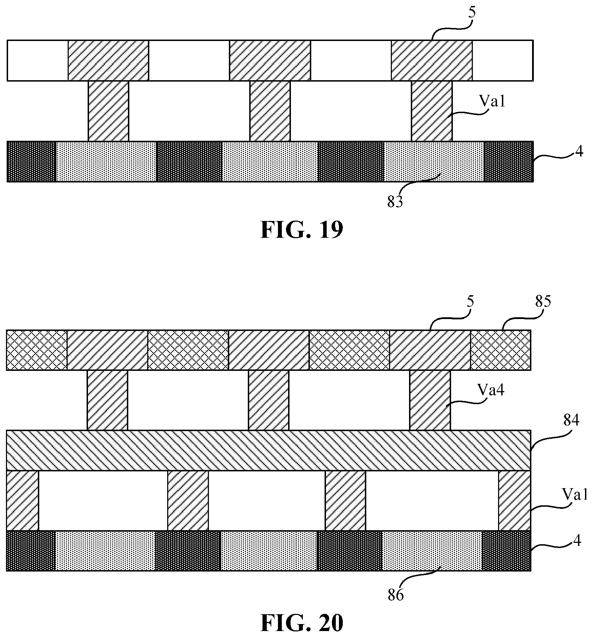

FIG. 19 is a cross-sectional schematic diagram of another exemplary display panel according to various disclosed embodiments of the present disclosure. As shown in FIG. 19, in some embodiments, the connection bus may include a third connection bus 83 located at the same layer as the light-shielding conductive structure 4 and electrically connected to the light-shielding conductive structure 4. The first power signal line 5 may be electrically connected to the third connection bus 83 through the first via hole Va1. In such a configuration way, the light-shielding conductive structure 4 may be electrically connected to the first power signal line 5 through the first via hole Va1 and the third connection bus 83, which may reduce the alignment requirements of the first power signal line 5 and the light-shielding conductive structure 4. For example, in the direction perpendicular to the plane where the substrate is located, the first power signal line 5 may not be required to overlap with the light-shielding conductive structure 4.

FIG. 20 is a cross-sectional schematic diagram of another exemplary display panel according to various disclosed embodiments of the present disclosure. As shown in FIG. 20, in some embodiments, the connection bus may include a fourth connection bus 84, a fifth connection bus 85, and a sixth connection bus 86. The fourth connection bus 84 may be located between the film layer where the first power signal line 5 is located and the film layer where the light-shielding conductive structure 4 is located. The fifth connection bus 85 may be located on the same layer as the first power signal line 5 and may be electrically connected to the first power signal line 5. The sixth connection bus 86 may be located on the same layer as the light-shielding conductive structure 4 and electrically connected to the light-shielding conductive structure 4. The fifth connection bus 85 may be electrically connected to the fourth connection bus 84 through the fourth via hole Va4, and the sixth connection bus 86 may be electrically connected to the fourth connection bus 84 through the first via hole Va1. In such a configuration, it may be only necessary to electrically connect the fifth connection bus 85 with the fourth connection bus 84 through the fourth via hole Va4, and electrically connect the sixth connection bus 86 with the fourth connection bus 84 through the first via hole Va1, so as to realize the electrical connection between the light-shielding conductive structure 4 and the first power signal line 5, such that the position selection of the first via hole Va1 and the fourth via hole Va4 may be more flexible, and the difficulty of drilling may be reduced.

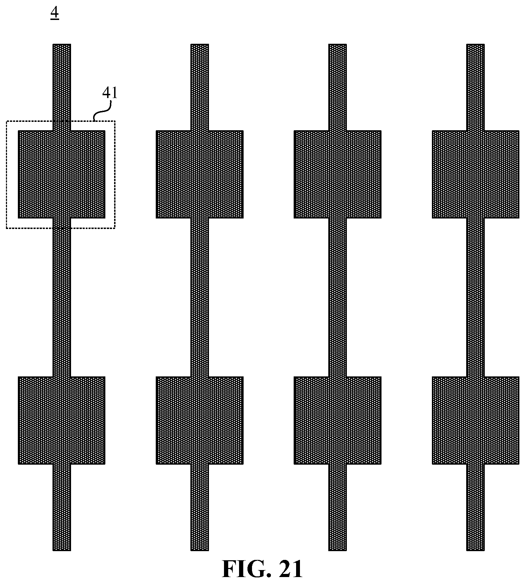

FIG. 21 is a schematic diagram of a partial layout structure of a light-shielding conductive structure according to various disclosed embodiments of the present disclosure. As shown in FIG. 21, in some embodiments, the light-shielding conductive structure 4 may include a plurality of light-shielding units 41. The light-shielding units 41 may cover the active layer of the driving transistor in a direction perpendicular to the plane where the substrate is located. Specifically, in a direction perpendicular to the plane where the substrate is located, the light-shielding units 41 may cover the channel region of the active layer, thereby avoiding the generation of photoinduced leakage current in the channel region.

In some embodiments, referring to FIG. 21, the light-shielding units 41 may be arranged in multiple rows and columns, and each column of light-shielding units 41 may be electrically connected, and the arrangement direction may be along the extension direction of the first power signal line. In such a way, each column of light-shielding units 41 may be electrically connected to a corresponding first power signal line. For each column of light-shielding units 41, a first via hole may be separately drilled to realize the electrical connection between each column of light-shielding units 41 and the corresponding first power signal line, which may be conducive to voltage adjustment for each column of light-shielding units 41 such that the voltage distribution of all light-shielding units 41 may be more uniform.

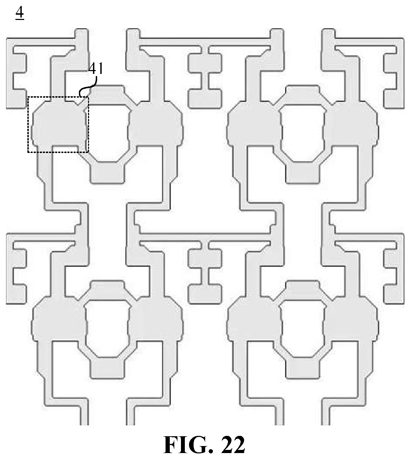

In some embodiments, FIG. 22 is a schematic diagram of another partial layout structure of an exemplary light-shielding conductive structure according to various disclosed embodiments of the present disclosure. As shown in FIG. 22, on the basis of the above embodiments, each row of light-shielding units 41 may be electrically connected. In such a configuration, the entire light-shielding conductive structures 4 may be in a grid shape, thereby reducing the resistance of the light-shielding conductive structures 4, further reducing the voltage drop of the light-shielding conductive structure 4, and improving the uniformity of the voltage distribution on the light-shielding conductive structure 4. In addition, the light-shielding conductive structure 4 may be as a unity, and there may be no need to provide a first via hole corresponding to each column of light-shielding units or each first power signal line. Accordingly, the number of first via holes may be reduced, and the process cost may be reduced.

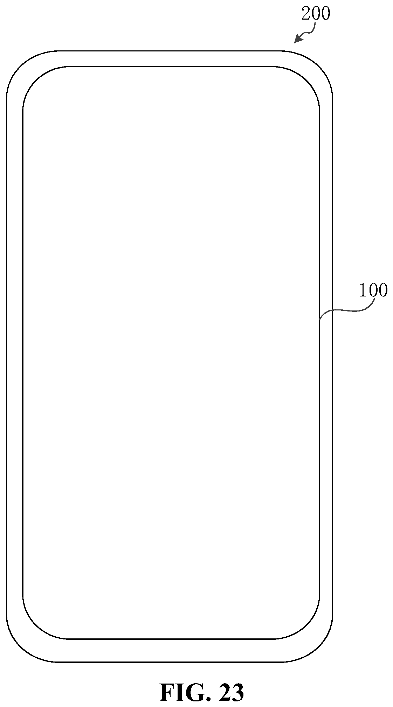

The present disclosure also provides a display device. FIG. 23 is a schematic diagram of the structure of an exemplary display device according to various disclosed embodiments of the present disclosure. As shown in FIG. 23, the display device 200 may include any display panel 100 provided in the above-mentioned embodiments and may include corresponding beneficial effects. To avoid repeated description, it is not described here.

The display device includes but is not limited to a mobile phone, a tablet computer, a car computer, a smart wearable device with a display function, and other structural components with a display function, which are not described here or limited.

It should be noted that, in this disclosure, relational terms such as "first" and "second" are only used to distinguish one entity or operation from another entity or operation, and do not necessarily require or imply any such actual relationship or order between these entities or operations. Moreover, the terms "include", "comprise" or any other variant thereof are intended to cover non-exclusive inclusion, such that a process, method, article or device including a series of elements includes not only those elements, but also other elements not explicitly listed, or also includes elements inherent to such process, method, article or device. In the absence of further restrictions, the elements defined by the sentence "including one..." do not exclude the existence of other identical elements in the process, method, article or device including the elements.

The above description is only a specific embodiment of the present disclosure, such that those skilled in the art can understand or implement the present disclosure. Various modifications to these embodiments will be apparent to those skilled in the art, and the general principles defined herein may be implemented in other embodiments without departing from the gist or scope of the disclosure. Therefore, the present disclosure will not be limited to the embodiments described herein, but will conform to the widest scope consistent with the principles and novel features disclosed herein.

## Claims

1. A display panel, comprising:
a display area;
a non-display area;
a substrate; and
a pixel, a light-shielding conductive structure and at least one first power signal line located on one side of the substrate,
wherein
a first end of the first power signal line is electrically connected to a power soldering pad;
the non-display area includes a first non-display area and a second non-display area;
the first non-display area, the display area and the second non-display area are arranged in sequence along a first direction;
the power soldering pad is located in the first non-display area;
the pixel includes a pixel driving circuit;
the pixel driving circuit includes a driving transistor;
the light-shielding conductive structure is located on a side of an active layer of the driving transistor adjacent to the substrate;
at least one of the first power signal line is electrically connected to the light-shielding conductive structure through at least one first via hole; and
in an extension direction of the first power signal line, a distance between any two first via holes is less than a length of the first power signal line, wherein the at least one first via hole is in contact with a film layer where the light-shielding conductive structure is located.

2. The display panel according to claim 1, wherein
the first via hole is located in the non-display area.

3. The display panel according to claim 2, wherein
the display panel also includes a power extension line electrically connected to the first power signal line, wherein the first via hole and the power extension line are both located in the second non-display area, and the light-shielding conductive structure is electrically connected to the power extension line through the first via hole; or
the display panel also includes a power lead electrically connected to the first power signal line, wherein the first via hole and the power lead are both located in the first non-display area, and the light-shielding conductive structure is electrically connected to the power lead through the first via hole.

4. The display panel according to claim 1, further comprising:
a connection bus, wherein multiple first power signal lines are electrically connected to the light-shielding conductive structure through the connection bus.

5. The display panel according to claim 4, wherein
in a direction perpendicular to a plane where the substrate is located, the connection bus covers the first via hole.

6. The display panel according to claim 1, wherein
in an extension direction of the first power signal line, a distance between any two first via holes is equal to 0; and
in a direction perpendicular to the plane where the substrate is located, the first via hole overlaps with a connection line of a first end of each first power signal line.

7. The display panel according to claim 1, wherein
in an extension direction of the first power signal line, a distance between any two first via holes is equal to approximately 0;
in a direction perpendicular to a plane where the substrate is located, the first via hole overlaps with a connection line of a second end of each the first power signal line; and
the second end is an end of the first power signal line opposite to the first end.

8. The display panel according to claim 1, wherein
in a direction perpendicular to a plane where the substrate is located, the first via hole is located between a connection line of a first end of each the first power signal line and a connection line of a second end of each the first power signal line; and
the second end is an end of the first power signal line opposite to the first end.

9. The display panel according to claim 1, wherein
the first power signal line is also electrically connected to the light-shielding conductive structure through a second via hole;
the second via hole is in contact with a film layer where the first power signal line is located; and
at least two of first power signal lines have a same voltage at the second via hole.

10. The display panel according to claim 4, wherein
the connection bus includes a first connection bus;
the first connection bus is located between a film layer where the first power signal line is located and a film layer where the light-shielding conductive structure is located;
the first power signal line is electrically connected to the first connection bus through a third via hole; and
the light-shielding conductive structure is electrically connected to the first connection bus through the first via hole.

11. The display panel according to claim 10, wherein
in a direction perpendicular to a plane where the substrate is located, the first via hole and the third via hole do not overlap.

12. The display panel according to claim 10, further comprising:
a second power signal line,
wherein
an extension direction of the second power signal line intersects an extension direction of the first power signal line, and the second power signal line is electrically connected to the first power signal line; and
the first connection bus and the second power signal line are located in a same layer.

13. The display panel according to claim 4, wherein
the connection bus includes a second connection bus; the second connection bus is located in a same layer as the first power signal line and is electrically connected to the first power signal line; and the light-shielding conductive structure is electrically connected to the second connection bus through the first via hole; or
the connection bus includes a third connection bus; the third connection bus is located in a same layer as the light-shielding conductive structure and is electrically connected to the light-shielding conductive structure; and the first power signal line is electrically connected to the third connection bus through the first via hole.

14. The display panel according to claim 4, wherein
the connection bus includes a fourth connection bus, a fifth connection bus and a sixth connection bus;
the fourth connection bus is located between a film layer where the first power signal line is located and a film layer where the light-shielding conductive structure is located;
the fifth connection bus is located in a same layer as the first power signal line and is electrically connected to the first power signal line;
the sixth connection bus is located in a same layer as the light-shielding conductive structure and is electrically connected to the light-shielding conductive structure;
the fifth connection bus is electrically connected to the fourth connection bus through a fourth via hole; and
the sixth connection bus is electrically connected to the fourth connection bus through the first via hole.

15. The display panel according to claim 1, wherein the light-shielding conductive structure comprises:
a plurality of light-shielding units, wherein, in a direction perpendicular to a plane where the substrate is located, a light-shielding unit of the plurality of light-shielding units covers an active layer of the driving transistor.

16. The display panel according to claim 15, wherein
the plurality of light-shielding units are arranged in multiple rows and multiple columns; and
light-shielding conductive units in each column are electrically connected, and an arrangement direction is along an extension direction of the first power signal line.

17. The display panel according to claim 16, wherein
each row of light-shielding units are electrically connected.

18. The display panel according to claim 1, wherein the pixel driving circuit comprises:
a storage capacitor, wherein a first plate of the storage capacitor is electrically connected to the first power signal line, and a second plate of the storage capacitor is electrically connected to a gate of the driving transistor.

19. The display panel according to claim 1, wherein the pixel driving circuit further comprises:
a gate located on a side of an active layer of the driving transistor away from the substrate.

20. A display device, comprising the display panel according to any one of claims 1 to 19.
